# EUROPEAN PATENT SPECIFICATION

(11) **EP 4 558 571 B1**
(45) Date of publication and mention of the grant of the patent: **08.04.2026**
(21) Application number: 23744432.8
(22) Date of filing: 18.07.2023
(51) Int. Cl.: C09D 11/38, C09D 11/101

(54) **A CURABLE INKJET COMPOSITION FOR THE MANUFACTURING OF PRINTED CIRCUIT BOARDS**
HÄRTBARE TINTENSTRAHLZUSAMMENSETZUNG ZUR HERSTELLUNG VON LEITERPLATTEN
COMPOSITION JET D'ENCRE DURCISSABLE POUR LA FABRICATION DE CARTES DE CIRCUIT IMPRIMÉ

(30) Priority: 19.07.2022 EP 22185656
(43) Date of publication of application: 28.05.2025
(73) Proprietor: AGFA-GEVAERT NV, 2640 Mortsel (BE)
(72) Inventor: SAUVAGEOT, Marion, 2640 Mortsel (BE); MUNYESHYAKA, Jeannette, 2640 Mortsel (BE)
(74) Representative: Goethals, Fabienne
(86) International application number: PCT/EP2023/069862
(87) International publication number: WO 2024/017864

(56) References cited:
- EP-A1- 3 054 752
- EP-A1- 3 778 657
- EP-A1- 4 190 866
- US-A1- 2021 403 737

## Description

### Technical Field

The present invention relates to a curable composition for use as an ink jet composition in the manufacturing of electronic devices. The invention also relates to a cured product of said composition.

### Background Art

Printed Circuit Boards (PCBs) are traditionally manufactured in an extensive process including multiple photolithographic and etching steps, thereby generating a lot of waste. In order to reduce the amount of process steps, production costs, and waste, there is an increased interest in digitalizing the PCB manufacturing workflow.

Inkjet printing is a preferred digital manufacturing technology for several PCB production steps, such as the application of the etch resist and the solder mask, or printing of the legend.

The PCB solder mask, or solder resist, acts as an insulator between the copper traces, and prevents the formation of solder bridges. Moreover, it plays an important role in protecting the board against oxidation triggered by outer influences, such as weather conditions, temperature variations, and humidity. When mechanical defects occur in the solder mask due to exposure to these external conditions, the protective and insulating function of the solder mask can be negatively affected. Therefore, the main objective for producing an effective solder mask is to provide a good resistance against the conditions to which it is exposed.

For the production of a PCB solder mask via ink jet, a first requirement is that the cured ink has a good adhesion on various substrates, such as copper and FR-4.

The adhesion on various substrates may be improved by adding adhesion promotors, as disclosed in WO2004/026977 and WO2004/105 (Avecia). WO2018/087056 (Agfa-Gevaert /Electra Polymers) discloses a combination of an adhesion promoter with a compound including at least two phenolic groups. However, the presence of adhesion promotors may result in a poor stability of the inkjet ink.

A second requirement is that the solder mask has to be able to withstand the severe conditions during typical finishing processes, such as soldering (solder resistance) and ENIG plating (ENIG plating resistance). Especially the ENIG plating process wherein severe and varying conditions (pH and temperature) are used, is very demanding with regard to the adhesion requirements of the inkjet ink.

EP-A 4032958 (Agfa-Gevaert) discloses a radiation curable inkjet ink to prepare a solder mask, wherein the ink comprises a polymerizable compound, a phenolic resin and a thermal cross-linking agent. The combination of these compounds ensures a good adhesion and a good ENIG plating resistance.

EP-A 1624001 (Taiyo Ink Manufacturing) discloses an inkjet ink for solder mask printing comprising a (meth)acrylate monomer including a thermosetting functional group. WO2020/109769 (Electra Polymers) discloses an inkjet ink for solder mask printing comprising a reactive monomer, an oligomer of prepolymer containing at least one epoxy or oxetane functional group, a free radical polymerizable compound, a thermal cross-linking agent and a radical initiator.

However, even with a good adhesion and ENIG plating resistance, it may still be possible that cracks appear in the solder mask, as a result of thermal stress occurring during the soldering of electronic components on the PCB, or due to heat variations during the lifetime of the PCB. Because of this, the printed and cured solder mask has to resist several thermal stress tests, such as immersion in a solder bath and IR reflow. These stress tests are especially relevant when performed after the ENIG plating process.

EP-A 3778793 (Taiyo Ink Manufacturing) discloses an inkjet ink for solder mask printing, comprising a photopolymerizable monomer with a cyclic skeleton and a shrinkage of less than 10%, which results in an improved heat resistance before ENIG plating.

EP-A 3054752 (Taiyo Ink Manufacturing), US-A 2021/0403737 (Electra Polymers Ltd.) and EP-A 3778657 (Taiyo Ink Manufacturing) disclose curable inkjet compositions for a printed circuit board, comprising a polymerizable compound and a thermal cross-linking agent comprising an isocyanate or a triazine compound.

However, there is still a need for inkjet inks for use in a PCB manufacturing process that have a good resistance to thermal stress tests before and after ENIG plating, while also having a good ENIG plating resistance and having sufficient ink stability.

### Summary of invention

It is an object of the invention to provide a curable composition for solder mask printing in the manufacturing of printed circuit boards (PCBs), combining a good stability, a good resistance to the ENIG plating process and a good heat resistance before and after the ENIG plating process.

The object of the invention is realized by the curable composition as defined in claim 1.

Further objects of the invention will become apparent from the description hereinafter.

### Description of embodiments

### Definitions

The term "monofunctional" in e.g. monofunctional polymerizable compound means that the polymerizable compound includes one polymerizable group.

The term "difunctional" in e.g. difunctional polymerizable compound means that the polymerizable compound includes two polymerizable groups.

The term "polyfunctional" or "multifunctional" in e.g. polyfunctional polymerizable compound means that the polymerizable compound includes more than two polymerizable groups.

The term "alkyl" means all variants possible for each number of carbon atoms in the alkyl group i.e. methyl, ethyl, for three carbon atoms: n-propyl and isopropyl; for four carbon atoms: n-butyl, isobutyl and tertiary-butyl; for five carbon atoms: n-pentyl, 1,1-dimethyl-propyl, 2,2-dimethylpropyl and 2-methyl-butyl, etc.

Unless otherwise specified a substituted or unsubstituted alkyl group is preferably a C₁ to C₆-alkyl group.

Unless otherwise specified a substituted or unsubstituted alkenyl group is preferably a C₂ to C₆-alkenyl group.

Unless otherwise specified a substituted or unsubstituted alkynyl group is preferably a C₂ to C₆-alkynyl group.

Unless otherwise specified a substituted or unsubstituted alkaryl group is preferably a phenyl or naphthyl group including one, two, three or more C₁ to C₆-alkyl groups.

Unless otherwise specified a substituted or unsubstituted aralkyl group is preferably a C₇ to C₂₀-alkyl group including a phenyl group or naphthyl group.

Unless otherwise specified a substituted or unsubstituted aryl group is preferably a phenyl group or naphthyl group

Unless otherwise specified a substituted or unsubstituted heteroaryl group is preferably a five- or six-membered ring substituted by one, two or three oxygen atoms, nitrogen atoms, sulphur atoms, selenium atoms or combinations thereof.

The term "substituted", in e.g. substituted alkyl group means that the alkyl group may be substituted by other atoms than the atoms normally present in such a group, i.e. carbon and hydrogen. For example, a substituted alkyl group may include a halogen atom or a thiol group. An unsubstituted alkyl group contains only carbon and hydrogen atoms

Unless otherwise specified a substituted alkyl group, a substituted alkenyl group, a substituted alkynyl group, a substituted aralkyl group, a substituted alkaryl group, a substituted aryl and a substituted heteroaryl group are preferably substituted by one or more constituents selected from the group consisting of methyl, ethyl, n-propyl, isopropyl, n-butyl, isobutyl and tertiary-butyl, ester, amide, amine, ether, thioether, ketone, aldehyde, sulfoxide, sulfone, sulfonate ester, sulphonamide, -Cl, -Br, -I, -OH, -SH, -CN and -NO₂.

Unless otherwise specified an alkyl, a cycloalkyl or an aryl interrupted by a heteroatom means that a heteroatom in present in the carbon chain of said group, for example -C-O-C-C- or -C-S-C-C-.

### Curable inkjet composition

The curable composition according to the present invention comprises
- more than one polymerizable compound, of which at least one polymerizable compound contains a vinyl group selected from the group consisting of a vinylether group, an N-vinyl amide group and an N-vinyl carbamate group;
- one or more thermal cross-linking agent selected from the group consisting of an unblocked isocyanate, a blocked isocyanate and a triazine compound;
characterized in that at least one polymerizable compound is a methacrylate, wherein the amount of methacrylate is more than 2.5 wt% relative to the total weight of the curable inkjet composition.

The composition is preferably a radiation-curable composition. Any type of radiation may be applied, but preferred radiation types are UV-light and UV-LED light. Therefore, the curable composition according to the present invention is preferably a UV-curable composition.

In a preferred embodiment, the composition according to the present invention comprises a mixture of UV-curable compounds and thermal cross-linking agents. Therefore, the curable composition according to the present invention is preferably also a thermally curable composition. Any type of heat source may be used for the thermal curing step, but preferably the thermal curing is performed in an oven.

The two curing processes, thermal and UV, can take place simultaneously or sequentially. This so-called dual-cure principle results in the formation of an interpenetrating polymer network, which the inventors believe to be the reason for the observed superior mechanical properties compared to the individually cured polymer networks.

The curable composition according to the invention is preferably applied as an inkjet ink.

For reliable industrial inkjet printing, the viscosity of the curable inkjet ink is preferably no more than 20 mPa.s at 45 ° C, more preferably from 1 to 18 mPa.s at 45 ° C, and most preferably from 5 to 15 mPa.s at 45 ° C, all at a shear rate of 1000 s⁻¹.

A preferred jetting temperature is from 10 to 70 ° C, more preferably from 20 to 55 ° C, and most preferably from 25 to 50 ° C.

For good image quality and adhesion, the surface tension of the curable inkjet ink is preferably from 18 to 70 mN/m at 25 ° C, more preferably from 20 to 40 mN/m at 25 ° C.

### Polymerizable compounds

The curable inkjet composition according to the present invention comprises more than one polymerizable compound, of which at least one polymerizable compound contains a vinyl group selected from the group consisting of a vinylether group, an N-vinyl amide group and an N-vinyl carbamate group.

The polymerizable compounds are preferably free radical polymerizable compounds. The free radical polymerizable compounds may be monomers, oligomers and/or prepolymers. These monomers, oligomers and/or prepolymers may possess different degrees of functionality, i.e. a different amount of free radical polymerizable groups. A mixture including combinations of mono-, di-, tri-and higher functional monomers, oligomers and/or prepolymers may be used. The viscosity of the curable inkjet ink may be adjusted by varying the ratio between the monomers and oligomers.

The polymerizable compounds may also comprise functional groups, such as thiols, hydroxyls, amines, sulfonic acids, phosphoric acids, and carboxylic acids. Examples of hydroxyl-functionalized polymerizable compounds are those listed in paragraphs [0028] to [0029] in US2015/0090482A.

Preferred polymerizable compounds are those listed in paragraphs [0106] to [0115] in EP-A 1911814.

Especially preferred polymerizable compounds are selected from the group consisting of 2-ethylhexyl acrylate, lauryl acrylate, stearyl acrylate, 3,3,5-trimethylcyclohexyl acrylate, isobornyl acrylate, hexanediol diacrylate, trimethylolpropane triacrylate, polyethyleneglycol diacrylate, 2-phenoxyethyl acrylate, and acryloyl morpholine.

At least one polymerizable compound of the curable inkjet composition contains a vinyl group selected from the group consisting of a vinylether group, an N-vinyl amide group and an N-vinyl carbamate group.

Preferred examples of polymerizable compounds containing a vinylether group or an N-vinylamide group are those listed in paragraphs [0047] to [0056] in EP-A 3686251.

A particularly preferred vinylether containing polymerizable compound is 2-(2-vinyloxyethoxy)ethyl acrylate, as it is advantageous in providing a good balance between the curability and the viscosity of the curable inkjet composition, especially when it is used in an amount of 5 wt%, preferably at least 7.5 wt% and most preferably at least 10 wt% based on the total weight of the curable inkjet composition.

Particularly preferred vinylamide containing polymerizable compounds are N-vinyl-2-pyrrolidone and N-vinylcaprolactam as they combine a high Tg with a good ink curability and a good adhesion of a cured ink layer to a recording medium.

The polymerizable compound containing an N-vinyl carbamate group is preferably a cyclic compound represented by General Formula I. 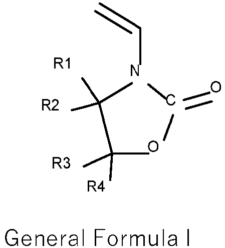 wherein R1, R2, R3 and R4 independently from each other represent hydrogen, alkyl, cycloalkyl, or aryl and combinations thereof, any of which may be interrupted by heteroatoms. Any of R1 to R4 may represent the necessary atoms for forming a five-or six-membered ring.

Preferably R1, R2, R3 and R4 independently from each other represent hydrogen or a substituted or unsubstituted C₁ to C₁₀ alkyl group.

Preferred compounds are disclosed in WO 2015/022228 (BASF) and US 4831153 (DOW CHEMICAL).

Cyclic compounds according to General Formula I are often referred to as oxazolidinones. A particularly preferred oxazolidinone is N-vinyl-5-methyl-2-oxazolidinone, also referred to as vinyl methyl oxazolidinone, or VMOX. Including VMOX improves the hardness of the cured ink layer, especially when it is used in an amount from 1 to 50 wt%, preferably from 2.5 to 40 wt%, and most preferably from 5 to 30 wt% based on the total weight of the curable inkjet composition. Moreover, VMOX has a low viscosity compared to other N-vinyl compounds, which makes it especially suitable for ink jet printing.

The polymerizable compound containing a vinylether, an N-vinylamide or an N-vinyl carbamate may be used singly or in a combination of one or more polymerizable compounds containing a vinylether, an N-vinylamide or an N-vinyl carbamate.

The curable composition according to the present invention comprises at least one methacrylate, i.e. any ester of methacrylic acid. The methacrylate may be a monofunctional, a difunctional, or a multi-functional methacrylate. The methacrylate compound may also comprise other functional groups, such as, without being limited thereto, hydroxyls, thiols, amines, sulfonic acids, phosphoric acids, and carboxylic acids. A mixture of methacrylates may be used.

Without limitation, preferred methacrylates are methyl methacrylate, ethyl methacrylate, isopropyl methacrylate, n-propyl methacrylate, n-butyl methacrylate, isobutyl methacrylate, t-butyl methacrylate, hexyl methacrylate, ethylhexyl methacrylate, hydroxymethyl methacrylate, 2-hydroxyethyl methacrylate, 2-hydroxypropyl methacrylate, 2-hydroxybutyl methacrylate, 4-hydroxybutyl methacrylate, hydroxypentyl methacrylate, hydroxyhexyl methacrylate, 1,4-butanediol dimethacrylate, 1,6-hexanediol dimethacrylate, 1,8-octanediol dimethacrylate, 1,9-nonanediol dimethacrylate, 1,10-decanediol dimethacrylate, 1,11-undecanediol dimethacrylate, 1,12-dodecanediol dimethacrylate, triethyleneglycol dimethacrylate, diethyleneglycol dimethacrylate, ethyleneglycol dimethacrylate, 2-(2-vinyloxy ethoxy)ethyl methacrylate, isoamyl methacrylate, stearyl methacrylate, lauryl methacrylate, octyl methacrylate, decyl methacrylate, isoamylstyl methacrylate, isostearyl methacrylate, 2-ethylhexyl methacrylate, methacryloyl morpholine, 2-ethylhexyl-diglycol methacrylate, 2-methacryloyloxyethylhexahydrophthalic acid, butoxyethyl methacrylate, ethoxydiethylene glycol methacrylate, methoxydiethylene glycol methacrylate, methoxypolyethylene glycol methacrylate, methoxypropylene glycol methacrylate, phenoxyethyl methacrylate, tetrahydrofurfuryl methacrylate, isobornyl methacrylate, 3,3,5-trimethylcyclohexyl methacrylate, 2-hydroxy-3-phenoxypropyl methacrylate, vinyl ether methacrylate, 2-methacryloyloxyethylsuccinic acid, 2-methacryloxyethylphthalic acid, 2-methacryloxyethyl-2-hydroxyethyl-phthalic acid, lactone modified flexible methacrylate, t-butylcyclohexyl methacrylate, triethylene glycol dimethacrylate, tetraethylene glycol dimethacrylate, polyethylene glycol dimethacrylate, dipropylene glycol dimethacrylate, tripropylene glycol dimethacrylate, polypropylene glycol dimethacrylate, 1,4-butanediol dimethacrylate, neopentyl glycol dimethacrylate, dimethylol-tricyclodecane dimethacrylate, bisphenol A EO (ethylene oxide) adduct dimethacrylate, bisphenol A PO (propylene oxide) adduct dimethacrylate, hydroxypivalate neopentyl glycol dimethacrylate, propoxylated neopentyl glycol dimethacrylate, alkoxylated dimethyloltricyclodecane dimethacrylate and polytetramethylene glycol dimethacrylate, trimethylolpropane trimethacrylate, EO modified trimethylolpropane trimethacrylate, tri (propylene glycol) trimethacrylate, caprolactone modified trimethylolpropane trimethacrylate, pentaerythritol trimethacrylate, pentaerithritol tetramethacrylate, pentaerythritolethoxy tetramethacrylate, dipentaerythritol hexamethacrylate, ditrimethylolpropane tetramethacrylate, glycerinpropoxy trimethacrylate, and caprolactam modified dipentaerythritol hexamethacrylate.

Particularly preferred methacrylates are 2-ethylhexyl methacrylate, lauryl methacrylate, stearyl methacrylate, 3,3,5-trimethylcyclohexyl methacrylate, isobornyl methacrylate, 1,6-hexanediol dimethacrylate, trimethylolpropane trimethacrylate, 2-(2'-vinyloxyethoxy)ethylmethacrylate, and polyethyleneglycol dimethacrylate.

It was found that a cured layer from a curable inkjet composition containing a certain amount of a methacrylate compound exhibits better heat resistance. This is attributed to a lower curing speed of the composition, resulting in lower shrinkage of the cured layer and a better adhesion. To achieve this effect, the amount of the methacrylate compound in the curable inkjet composition is more than 2.5 wt%, preferably more than 5 wt% based on the total weight of the curable inkjet composition.

However, when the amount of methacrylate is too high, the cured solder mask may not be efficiently cured, reducing the heat resistance of the cured layer.

The amount of the methacrylate compound in the curable inkjet composition is therefore preferably not more than 15 wt%, more preferably not more than 12.5 wt%, most preferably not more than 10 wt%.

### Thermal cross-linking agent

The curable composition of the present invention comprises one or more thermal cross-linking agent selected from the group consisting of unblocked isocyanates, blocked isocyanates and triazine compounds. The presence of a thermal cross-linking agent may improve the adhesion of the obtained coating film after soldering or ENIG plating.

The thermal cross-linking agent may be monofunctional, difunctional or multifunctional.

The inkjet composition may comprise a mixture of different thermal cross-linking agents.

Preferred thermal cross-linking agents are oxiranes, oxetanes, melamine-formaldehyde resins, urea-formaldehyde resins, benzoguanamine-formaldehyde resins, cyclic carbonate compounds, carbodiimides, isocyanates, blocked isocyanates, and combinations thereof.

Preferred thermal cross-linking agents are isocyanate compounds. Isocyanate compounds are preferably used in combination with a compound comprising active hydrogen functionalities, including, without limitation, alcohols, thiols, amines, water, or combinations thereof. Atmospheric moisture may also cause isocyanate cross-linking. When atmospheric moisture is reacting with an isocyanate, it may not be necessary to prepare an ink combining the isocyanate compound with a compound comprising active hydrogen functionalities.

The isocyanate compound may be an aliphatic, an alicyclic or an aromatic isocyanate. In case the isocyanate compound is a multifunctional isocyanate, it may comprise a combination of aliphatic, alicyclic or aromatic isocyanate functionalities.

Examples of aliphatic isocyanates include, without limitation, 1,6-hexamethylene diisocyanate (HDI or HMDI), isophorone diisocyanate (IPDI), 1,3-(isocyanatomethyl)cyclohexane (hydrogenated XDI), lysine diisocyanate (LDI), 2,2,4-trimethyl hexamethylene diisocyanate (TMDI), and dimeryl diisocyanate (DDI).

Examples of alicyclic isocyanates include, without limitation, isophorone diisocyanate (IPDI), methylcyclohexane 2,4-(2,6)-diisocyanate (hydrogenated TDI), and 4,4'-methylenebis(cyclohexylisocyanate) (hydrogenated MDI).

Examples of aromatic isocyanates include, without limitation, toluene diisocyanate (TDI), 1,5-naphthalene diisocyanate (NDI), 4,4'-di-phenyl-methanediisocyanate (MDI) and xylylene diisocyanate (XDI).

Examples also include adducts (e.g. trimethylol propane adducts), uretdiones, biurets, and isocyanurates of the isocyanates listed above.

The isocyanate compound may be blocked or unblocked, preferably blocked.

A blocked isocyanate can be obtained by reacting an isocyanate with a blocking agent of choice. Such a blocking agent is a protective group, which is cleaved off at elevated temperatures, for example during a thermal curing process. The blocking agent can be chosen such that it will cleave off at a certain temperature, the so-called de-blocking temperature. Using a blocked isocyanate typically improves the storage stability of the inkjet ink.

Examples of the blocking agent include alcohols such as ethanol, n-propanol, isopropanol, t-butanol, and isobutanol; phenols such as phenol, chlorophenol, cresol, xylenol, and p-nitrophenol; alkylphenols such as p-t-butylphenol, p-sec-butylphenol, p-sec-amylphenol, p-octylphenol, and p-nonylphenol; basic nitrogen-containing compounds such as 3-hydroxypyridine, S-hydroxyquinoline, and 8-hydroxyquinaldine; active methylene compounds such as diethyl malonate, ethyl acetoacetate, and acetylacetone; acid amides such as acetamide, acrylamide, and acetanilide; acid imides such as succinimide and maleic imide; imidazoles such as 2-ethylimidazole and 2-ethyl-4- methylimidazole; pyrazoles such as pyrazole, 3-methylpyrazole, and 3,5-dimethylpyrazole; lactams such as 2-pyrrolidone and 8-caprolactam; oximes of ketone or aldehyde, such as acetoxime, methyl ethyl ketone oxime, cyclohexanone oxime, and acetaldoxime; ethyleneimine; and bisulfite.

Hindered secondary amines may be used as blocking agents for toxicology reasons. Preferred hindered secondary amines are selected form the group consisting of ethyl-tert-butyl amine, diisopropyl amine, 2,6-dimethyl-piperidine, ethyl-isopropyl amine, di-tert-butyl amine and diisobutyl amine.

A preferred blocked isocyanate compound is a blocked HDI oligomer or a blocked IPDI oligomer. Such an oligomer can be for example a trimethylol propane adduct, a biuret, or an isocyanurate.

Particularly preferred blocked isocyanate compounds are Trixene BI 7960, a HDI biuret blocked with 3,5-dimethylpyrazole, commercially available from Lanxess and Trixene BI7982, a HDI trimer blocked with 3,5-dimethylpyrazole, commercially available from Lanxess.

Thermal cross-linking agents with a triazine skeleton are particularly preferred in the present invention. The triazine moiety is believed to contribute to the mechanical properties and heat resistance of the cured film. Any triazine compound having thermal cross-linking properties may be used.

A preferred triazine compound has a chemical structure according to General Formula II, 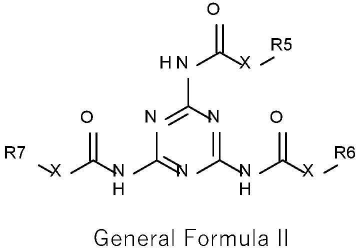
wherein X represents N, O, S, P or C;
R5, R6 and R7 independently from each other represent a substituted or unsubstituted alkyl group;
X preferably represents O or C, most preferably O.

Preferably, R5, R6 and R7 independently from each other represent a substituted or unsubstituted C1-C8 alkyl group. More preferably, R5, R6 and R7 independently from each other represent a group selected from the group consisting of methyl, ethyl, n-propyl, i-propyl, butyl, n-octyl, 2-ethyl hexyl.

Preferred triazine compounds according to General Formula II and their preparation method are disclosed in US5084541 (American Cyanamid Company).

Preferred triazine compounds according to General Formula II are commercially available from Allnex under the name Cymel^{®} NF 2000 and from BASF under the name Larotact^{®} 150.

The inkjet ink according to the present invention preferably includes a blocked isocyanate compound or a triazine compound according to General Formula II.

More preferably, the inkjet ink includes both a blocked isocyanate and a triazine compound according General Formula II.

The total amount of thermal cross-linking agents is preferably from 0.5 to 20 wt%, more preferably from 1 to 15 wt%, most preferably from 2 to 12 wt%, all relative to the total weight of the inkjet inks.

The amount of the blocked isocyanate compound is preferably from 0.1 to 12.5 wt%, more preferably from 2.5 to 10 wt%, most preferably from 5 to 8 wt%, all relative to the total weight of the inkjet ink.

The amount of the triazine compound is preferably from 0.1 to 5 wt%, more preferably from 0.5 to 4 wt%, most preferably from 1 to 3 wt%, all relative to the total weight of the inkjet ink.

When both a triazine compound and an isocyanate compound are present in the inkjet ink, the amount of the blocked isocyanate compound is preferably higher compared to the amount of the triazine compound. The ratio of the amount of the triazine compound to the amount of the isocyanate compound is preferably from 0.05 to 0.95, more preferably from 0.15 to 0.7.

It has been observed that the presence of thermal cross-linking agents improves various solder resist properties such as resistance to heat, hardness, resistance to soldering heat, resistance to chemicals, electrical insulating properties, and resistance to electroless plating and immersion plating.

### Photoinitiators

The curable inkjet composition preferably includes a photoinitiator, preferably a free radical photoinitiator.

A free radical photoinitiator is a chemical compound that initiates polymerization of monomers and oligomers when exposed to actinic radiation by the formation of a free radical. A Norrish Type I initiator is an initiator which cleaves after excitation, yielding the initiating radical immediately. A Norrish type II-initiator is a photoinitiator which is activated by actinic radiation and forms free radicals by hydrogen abstraction from a second compound that becomes the actual initiating free radical. This second compound is called a polymerization synergist or co-initiator. Both type I and type II photoinitiators can be used in the present invention, alone or in combination.

Suitable photoinitiators are disclosed in CRIVELLO, J.V., et al. Photoinitiators for Free Radical, Cationic and Anionic Photopolymerization. 2nd edition. Edited by BRADLEY, G. London, UK: John Wiley and Sons Ltd, 1998. p.276-293.

Specific examples of free radical photoinitiators may include, but are not limited to, the following compounds or combinations thereof: benzophenone and substituted benzophenones; 1-hydroxycyclohexyl phenyl ketone; thioxanthones such as isopropylthioxanthone; 2-hydroxy-2-methyl-1-phenylpropan-1-one; 2-benzyl-2-dimethylamino- (4-morpholinophenyl) butan-1-one; benzyl dimethylketal; 2-methyl-1- [4- (methylthio) phenyl] -2-morpholinopropan-1-one; 2,2-dimethoxy-1, 2-diphenylethan-1-one or 5,7-diiodo-3- butoxy-6-fluorone.

A preferred photoinitiator is a thioxanthone compound, such as Darocur ITX, an isomeric mixture of 2- and 4-isopropylthioxanthone.

Another preferred photoinitiator is an acylphosphine oxide compound. The acylphosphine oxide compound may be selected from the group consisting of a mono-acylphosphine oxide and a di-acylphosphine oxide. Preferred acylphosphine oxide photoinitiators are diphenyl(2,4,6-trimethylbenzoyl)phosphine oxide (TPO), ethyl (2,4,6-trimethylbenzoyl) phenyl phosphinate (TPO-L), phenylbis(2,4,6-trimethylbenzoyl)phosphine oxide) (BAPO), bis (2,6- dimethyl-benzoyl)-2,4,4-trimethylpentylphosphine oxide and 2,4,6-trimethoxybenzoyl-diphenylphosphine oxide.

Other preferred photoinitiators are α -hydroxy-ketone Type I photoinitiators such as for example oligo[2-hydroxy-2-methyl-1-[4-(1-methylvinyl-phenyl]propanone] available as Esacure^{®} KIP IT from IGM resins.

A preferred amount of photoinitiator is from 0.2 to 20 wt%, more preferably from 0.5 to 10 wt%, most preferably from 1 to 8 wt%, particularly preferred from 1.5 to 6 wt%, all relative to the total weight of the curable inkjet composition.

In order to increase the photosensitivity further, the curable inkjet composition may additionally contain co-initiators. Suitable examples of co-initiators can be categorized in three groups:
(1) tertiary aliphatic amines such as methyldiethanolamine, dimethylethanolamine, triethanolamine, triethylamine and N-methylmorpholine;
(2) aromatic amines such as amylparadimethyl-aminobenzoate, 2-n-butoxyethyl-4-(dimethylamino) benzoate, 2-(dimethylamino)-ethylbenzoate, ethyl-4-(dimethyl-amino)benzoate, and 2-ethylhexyl-4-(dimethylamino)benzoate; and
(3) (meth)acrylated amines such as dialkylamino alkyl(meth)acrylates (e.g., diethyl-aminoethylacrylate) or N-morpholinoalkyl-(meth)acrylates (e.g., N-morpholinoethyl-acrylate).

Preferred co-initiators are aminobenzoates.

A preferred low molecular aminobenzoate is Genocure^{®} EPD from RAHN.

Particularly preferred aminobenzoate co-initiators are selected from the group consisting of polymerisable, oligomeric and polymeric aminobenzoate co-initiators.

Polymerisable co-initiators are disclosed in EP-A 2033949 (Agfa Graphics N.V.).

In a more preferred embodiment, the aminobenzoate co-initiators are oligomeric aminobenzoate derivatives.

Particularly preferred aminobenzoates are polyether derivatives of aminobenzoates, wherein the polyether is selected from the group consisting of poly(ethylene oxide), poly(propylene oxide), copolymers thereof, and poly(tetrahydrofuran), ethoxylated or propoxylated neopentyl glycol, ethoxylated or propoxylated trimethylpropane and ethoxylated or propoxylated pentaerythritol.

Preferred oligomeric aminobenzoates are disclosed in WO1996/33157 (Lambson Fine Chemicals Ltd.) and WO2011/030089 (Sun Chemicals B.V.). Typical examples of polyethylene glycol bis p-dimethylaminobenzoate are OMNIPOL ASA, commercially available from IGM Resins and Speedcure 7040, commercially available from Lambson Fine Chemicals.

Other oligomeric or polymeric co-initiators are for example ESACURE A198, a polyfunctional amine from IGM and SARTOMER^{®} CN3755, an acrylated amine co-initiator from ARKEMA.

### Inhibitors

The curable inkjet composition may contain at least one inhibitor for improving the thermal stability of the ink.

Suitable polymerization inhibitors include phenol type antioxidants, hindered amine light stabilizers, phosphor type antioxidants, hydroquinone monomethyl ether commonly used in (meth)acrylate monomers, and hydroquinone, t-butyl-catechol, pyrogallol, 2,6-di-tert.butyl-4-methylphenol (=BHT) may also be used.

Suitable commercial inhibitors are, for example, Sumilizer^{™} GA-80, Sumilizer^{™} GM and Sumilizer^{™} GS produced by Sumitomo Chemical Co. Ltd.; Genorad^{™} 16, Genorad^{™}18 and Genorad^{™} 20 from Rahn AG; Irgastab^{™}UV10 and Irgastab^{™} UV22, Tinuvin^{™} 460 and CGS20 from Ciba Specialty Chemicals; Floorstab^{™} UV range (UV-1, UV-2, UV-5 and UV-8) from Kromachem Ltd, Additol^{™} S range (S100, S110, S120 and S130) from Cytec Surface Specialties.

Since excessive addition of these polymerization inhibitors may lower the curing speed, it is preferred that the amount capable of preventing polymerization is determined prior to blending. The amount of a polymerization inhibitor is preferably lower than 5 wt%, more preferably lower than 3 wt% of the total curable inkjet composition.

### Adhesion promotor

The curable inkjet composition may include an adhesion promoter to further optimize the adhesion of the cured composition to various surfaces, in particular a copper surface.

Any adhesion promoter may be used, for example those disclosed in WO2004/026977 and WO2004/105 both from AVECIA; WO2017/009097 and WO2020/104302 both from Agfa-Gevaert; and WO2018/087059, WO2018087052 WO2018087056 and WO2018087055, all from Agfa-Gevaert/Electra Polymers.

The curable inkjet composition may include one adhesion promoter or a combination of two, three or more different adhesion promoters.

The total amount of adhesion promoters is preferably from 0.1 to 20 wt%, more preferably from 0.5 to 15 wt%, most preferably from 1 to 10 wt%, all relative to the total weight of the inkjet composition.

However, it has been observed that an inkjet composition according to the present invention may have a sufficient adhesion, even after soldering, gold or ENIG plating, in the absence of an adhesion promoter. As the presence of adhesion promoters may result in a worse stability of the inkjet ink, the curable inkjet composition according to the present invention preferably does not contain an adhesion promoter. The amount of adhesion promotor is preferably less than 2.5 wt%, more preferably less than 1 wt%, most preferably less than 0.5 wt %, relative to the total weight of the composition.

### Flame retardant

The curable inkjet composition preferably comprises a flame retardant.

Preferred flame retardants are inorganic flame retardants, such as Alumina Trihydrate and Boehmite; organo-phosphor compounds, such as organo-phosphates (e.g. triphenyl phosphate (TPP), resorcinol bis (diphenylphosphate) (RDP), bisphenol A diphenyl phosphate (BADP), and tricresyl phosphate (TCP)); organo-phosphonates (e.g. dimethyl methylphosphonate (DMMP)); and organophosphinates (e.g. aluminium dimethylphosphinate).

Preferred flame retardants are disclosed in WO2019/121098.

### Colorants

The curable inkjet composition may be a substantially colourless inkjet ink or may include at least one colorant. For example, when the inkjet ink is used as etch resist, the colorant makes the temporary mask clearly visible to the manufacturer of conductive patterns, allowing a visual inspection of quality. When the inkjet ink is used to apply a solder mask it typically contains a colorant. A preferred colour for a solder mask is green, however other colours such as black or red may also be used.

The colorant may be a pigment or a dye, preferably a pigment.

A colour pigment may be chosen from those disclosed by HERBST, Willy, et al. Industrial Organic Pigments, Production, Properties, Applications. 3rd edition. Wiley - VCH, 2004. ISBN 3527305769. Suitable pigments are disclosed in paragraphs [0128] to [0138] of WO2008/074548.

Pigment particles in inkjet inks should be sufficiently small to permit free flow of the ink through the inkjet-printing device, especially at the ejecting nozzles. It is also desirable to use small particles for maximum colour strength and to slow down sedimentation. Most preferably, the average pigment particle size is not larger than 150 nm. The average particle size of pigment particles is preferably determined with a Brookhaven Instruments Particle Sizer BI90plus based upon the principle of dynamic light scattering.

Generally, dyes exhibit a higher light fading than pigments, but cause no problems on jettability. It was found that anthraquinone dyes exhibit only minor light fading under the normal UV curing conditions used in UV curable inkjet printing. In a preferred embodiment, the colorant in the curable inkjet ink is an anthraquinone dye, such as Macrolex^{™} Blue 3R (CASRN 325781-98-4) from LANXESS.

Other preferred dyes include crystal violet and a copper phthalocyanine dye.

It is possible to combine different colorants to obtain the desired colour, or to improve the dispersion stability. A preferred combination of colorants to obtain a green solder mask is a combination of a blue and a yellow colorant. In a particularly preferred embodiment, a combination of pigment yellow 150 and pigment blue 15:4 is used.

**In** a preferred embodiment, the colorant is present in an amount of 0.5 to 6.0 wt%, more preferably 0.75 to 2.5 wt%, based on the total weight of the curable inkjet ink.

### Polymeric dispersants

If the colorant in the curable inkjet ink is a pigment, then the curable inkjet ink preferably contains a dispersant, more preferably a polymeric dispersant, for dispersing the pigment.

Suitable polymeric dispersants are copolymers of two monomers but they may contain three, four, five or even more monomers. The properties of polymeric dispersants depend on both the nature of the monomers and their distribution in the polymer. Copolymeric dispersants preferably have the following polymer compositions:
- statistically polymerized monomers (e.g. monomers A and B polymerized into ABBAABAB);
- alternating polymerized monomers (e.g. monomers A and B polymerized into ABABABAB);
- gradient (tapered) polymerized monomers (e.g. monomers A and B polymerized into AAABAABBABBB);
- block copolymers (e.g. monomers A and B polymerized into AAAAABBBBBB) wherein the block length of each of the blocks (2, 3, 4, 5 or even more) is important for the dispersion capability of the polymeric dispersant;
- graft copolymers (graft copolymers consist of a polymeric backbone with polymeric side chains attached to the backbone); and
- mixed forms of these polymers, e.g. blocky gradient copolymers.

Suitable polymeric dispersants are listed in the section on "Dispersants", more specifically [0064] to [0070] and [0074] to [0077], in EP-A 1911814.

Commercial examples of polymeric dispersants are the following:
- DISPERBYK^{™} dispersants available from BYK CHEMIE GMBH;
- SOLSPERSE^{™} dispersants available from NOVEON;
- TEGO^{™} DISPERS^{™} dispersants from EVONIK;
- EDAPLAN^{™} dispersants from MÜNZING CHEMIE;
- ETHACRYL^{™} dispersants from LYONDELL;
- GANEX^{™} dispersants from ISP;
- DISPEX^{™} and EFKA^{™} dispersants from CIBA SPECIALTY CHEMICALS INC;
- DISPONER^{™} dispersants from DEUCHEM; and
- JONCRYL^{™} dispersants from JOHNSON POLYMER.

### Surfactants

The curable inkjet composition may contain at least one surfactant, which may act as wetting agent, dispersant or emulsifier.

The surfactant can be anionic, cationic, non-ionic, or zwitter-ionic.

Suitable surfactants include fluorinated surfactants, fatty acid salts, ester salts of a higher alcohol, alkylbenzene sulfonate salts, sulfosuccinate ester salts and phosphate ester salts of a higher alcohol (for example, sodium dodecylbenzenesulfonate and sodium dioctylsulfosuccinate), ethylene oxide adducts of a higher alcohol, ethylene oxide adducts of an alkylphenol, ethylene oxide adducts of a polyhydric alcohol fatty acid ester, and acetylene glycol and ethylene oxide adducts thereof (for example, polyoxyethylene nonylphenyl ether, and SURFYNOL^{™} 104, 104H, 440, 465 and TG available from AIR PRODUCTS & CHEMICALS INC.).

Preferred surfactants are selected from fluorinated surfactants (such as fluorinated hydrocarbons) and silicone surfactants. The silicone surfactants are preferably siloxanes and can be alkoxylated, polyether modified, polyether modified hydroxy functional, amine modified, epoxy modified and other modifications or combinations thereof. Preferred siloxanes are polymeric, for example polydimethylsiloxanes.

Preferred commercial silicone surfactants include BYK^{™} 333, BYK^{™} 347 and BYK^{™} UV3510 from BYK Chemie.

In a preferred embodiment, the surfactant is a polymerizable compound.

Preferred polymerizable silicone surfactants include a (meth)acrylated silicone surfactant. Most preferably the (meth)acrylated silicone surfactant is an acrylated silicone surfactant, because acrylates are more reactive than methacrylates. A preferred commercial acrylated surfactant is Ebecryl 1360 from Allnex.

In a preferred embodiment, the (meth)acrylated silicone surfactant is a polyether modified (meth)acrylated polydimethylsiloxane or a polyester modified (meth)acrylated polydimethylsiloxane.

Preferably the surfactant is present in the curable inkjet composition in an amount of 0 to 3 wt% based on the total weight of the curable inkjet composition.

### Preparation of the inkjet composition

The preparation of pigmented curable inkjet inks is well-known to the skilled person. Preferred methods of preparation are disclosed in paragraphs [0076] to [0085] of WO2011/069943.

### Method of manufacturing an electronic device

The method of manufacturing an electronic device according to the present invention includes at least one step wherein a curable inkjet composition as described above is jetted and cured on a substrate.

According to a preferred embodiment, the electronic device is a Printed Circuit Board (PCB).

In a particular preferred embodiment, the method of manufacturing a PCB includes a step wherein the solder mask composition is applied on the substrate via an inkjet printing step, followed with a UV-curing step and a heat treatment step.

The substrate is preferably a dielectric substrate containing an electrically conductive pattern, which typically comprises conductive pads electrically connected with each other using traces.

The dielectric substrate of the electronic device may be any non-conductive material. The substrate is typically a paper/resin composite or a resin/fibre glass composite, a ceramic substrate, a polyester or a polyimide. FR-4 is an example of a material frequently used as dielectric substrate.

The electrically conductive pattern is typically made from any metal or alloy which is conventionally used for preparing electronic devices such as gold, silver, palladium, nickel/gold, nickel, tin, tin/lead, aluminium, tin/aluminium and copper. The electrically conductive pattern is preferably made from copper.

Before applying the solder mask composition, the substrate is preferably subjected to one or more pre-treatment processes. These processes can be mechanical or chemical, or a combination thereof. A preferred pre-treatment process is chemical micro-etching, which typically results in micro-roughness on the substrate. A so-called anti-bleeding treatment can be additionally applied to the micro-etched surface to prevent bleeding of the ink into the micro-pores and to improve print quality. This anti-bleeding treatment typically comprises applying a coating layer on the substrate in order to adjust its surface energy, resulting in sharper contact angles and minimal bleeding of ink into micro-pores. Anti-bleeding treatments are preferably used when printing low-viscous compositions.

The process of inkjet printing the solder mask layer on a dielectric substrate with an electrically conductive pattern preferably comprises one or more printing steps as listed below.
- The printing of so-called "ramps" comprises printing lines next to the copper traces. This preparative printing step ensures a sufficient coverage of the Cu traces. If no ramps are printed next to the copper traces, the cured solder mask may be too thin on the edges (also called shoulders) of the copper traces. The thickness of the printed ramps is related to the height of the plated Cu traces. For plated Cu traces having a large height, a higher ramp ink thickness is required in order to have sufficient coverage on the Cu edges. For plated Cu traces with a lower height, a lower ramp thickness may be used. The ramps preferably have a thickness of 0 to 80 µm, more preferably from 10 to 60 µm, most preferably from 20 to 40 µm.
- The printing of so-called "dams" is usually done to indicate the contours of the entire solder mask layer. These dams are usually cured with higher curing energies to provide precise features and lines. The thickness of the dams is preferably at least the same as the thickness of the full solder mask layer. The thickness of the dams is more preferably higher than the thickness of the full solder mask layer, in order to avoid possible ink flow towards the open pad. The dams preferably have a thickness of 5 to 75 µm, more preferably from 10 to 60 µm, most preferably from 20 to 40 µm.
- Finally, the entire board is printed within the contours of the dams, covering the Cu traces, but leaving open the Cu pads for soldering.

The curable inkjet composition may be cured by exposing the composition to actinic radiation, such as electron beam or ultraviolet (UV) radiation. Preferably the curable inkjet composition is cured by UV radiation, more preferably using UV LED curing. To fixate the curable composition on the substrate, a UV pin curing step may be used immediately after printing. This UV pin curing may improve the print quality.

A heat treatment is preferably applied to the jetted and UV-cured curable inkjet composition. The heat treatment is preferably carried out at a temperature of from 80 ° C and 250° C. The temperature is preferably not less than 100° C, more preferably not less than 120 ° C. To prevent charring of the solder mask, the temperature is preferably not higher than 200 ° C, more preferably not higher than 160 ° C.

The thermal treatment is typically carried out from 15 to 90 minutes.

The purpose of the thermal treatment is two-fold: curing thermal cross-linking agents present in the curable composition, and further polymerizing potentially non-reacted radiation curable compounds. A dense interpenetrating polymer network can thus be created.

The method of manufacturing a PCB may comprise two, three or more inkjet printing steps. For example, the method may comprise two inkjet printing steps wherein an etch resist is provided on a metal surface in one inkjet printing step and wherein a solder mask is provided on a dielectric substrate containing an electrically conductive pattern in another inkjet printing step.

A third inkjet printing step may be used for legend printing.

### Inkjet printing devices

The curable inkjet composition may be jetted by one or more print heads ejecting small droplets in a controlled manner through nozzles onto a substrate, which is moving relative to the print head(s).

A preferred print head for the inkjet printing system is a piezoelectric head. Piezoelectric inkjet printing is based on the movement of a piezoelectric ceramic transducer when a voltage is applied thereto. The application of a voltage changes the shape of the piezoelectric ceramic transducer in the print head creating a void, which is then filled with ink. When the voltage is again removed, the ceramic expands to its original shape, ejecting a drop of ink from the print head. However, the inkjet printing method according to the present invention is not restricted to piezoelectric inkjet printing. Other inkjet print heads can be used and include various types, such as a continuous type.

The inkjet print head normally scans back and forth in a transversal direction across the moving ink-receiving surface (substrate). Often the inkjet print head does not print on the way back. Bi-directional printing is preferred for obtaining a high areal throughput. Another preferred printing method is by a " single pass printing process", which can be performed by using page wide inkjet print heads or multiple staggered inkjet print heads which cover the entire width of the ink-receiving surface. In a single pass printing process, the inkjet print heads usually remain stationary and the ink-receiving surface is transported under the inkjet print heads.

### Examples

### Materials

All materials used in the following examples were readily available from standard sources such as ALDRICH CHEMICAL Co. (Belgium) and ACROS (Belgium) unless otherwise specified. The water used was deionized water.
VEEA is 2-(vinylethoxy)ethyl acrylate available from NIPPON SHOKUBAI, Japan

PEA is 2-phenoxyethyl acrylate available as Sartomer^{™} SR339 from ARKEMA.

ACMO is acryloyl morpholine available from RAHN.

VMOX is N-vinyl-5-methyl-2-oxazolidinone available from BASF.

EHMA is 2-ethylhexyl methacrylate.

TMCHMA is 3,3,5-trimethylcyclohexyl methacrylate available as Sartomer^{™} SR421A from ARKEMA

IBOA is isobornyl acrylate available as Photomer 4012 from IGM resins.

IBOMA is isobornyl methacrylate available as Sartomer^{™} SR423D from ARKEMA.

HDDA is hexanediol diacrylate available as Sartomer^{™} SR238 from ARKEMA.

HDDMA is hexanediol dimethacrylate available as Sartomer^{™} SR239 from ARKEMA.

TMPTA is trimethylolpropane triacrylate available as Sartomer^{™} SR351 from ARKEMA.

TMPTMA is trimethylolpropane trimethacrylate available as Sartomer^{™} SR350 from ARKEMA.

VEEM is 2-(2'-vinyloxyethoxy)ethylmethacrylate available from NIPPON SHOKUBAI.

PEGDA is polyethyleneglycol diacrylate available as Sartomer^{™} SR259 from ARKEMA.

DAROCUR ITX is an isomeric mixture of 2- and 4-isopropylthioxanthone from BASF.

BAPO is a bis(2,4,6-trimethylbenzoyl)-phenylphosphineoxide photoinitiator available as Irgacure^{™} 819 from BASF.

BISAPHOS is a flame retardant containing a mixture of aromatic polyphosphates available from ADEKA.

Trixene BI7960 is a DMP-blocked isocyanate cross-linking agent commercially available from LANXESS.

Cymel NF2000A is a triazine cross-linking agent commercially available from ALLNEX.

Ebecryl 1360 is a silicone hexa-acrylate available from ALLNEX.

WET is a 1% solution of Ebecryl 1360 in VEEA.
Cyan is SUN FAST BLUE 15:4, a cyan pigment available from SUN CHEMICALS

Yellow is CROMOPHTAL YELLOW D 1085J, a yellow pigment from BASF.

INHIB is a mixture forming a polymerization inhibitor having a composition according to Table 1.

**Table 1**

| **Component** | **wt%** |
|---|---|
| DPGDA | 82.4 |
| p-methoxyphenol | 4.0 |
| 2,6-di-tert-butyl-4-methylphenol | 10.0 |
| Cupferron^{™} AL | 3.6 |

Cupferron^{™} AL is aluminium N-nitrosophenylhydroxylamine from WAKO CHEMICALS LTD.

PRECIP 162 is a dispersing agent and has been precipitated from Disperbyk 162, a dispersant solution available from BYK (ALTANA).

DISP is a solution of 30 wt% PRECIP 162 and 1 wt% INHIB in VEEA.

GD is a green dispersion prepared as follows:
A concentrated green dispersion, GD, was prepared having a composition according to Table 2.

**Table 2**

| **Component** | **wt%** |
|---|---|
| Cyan | 7.5 |
| Yellow | 7.5 |
| DISP | 15 |
| INHIB | 1 |
| VEEA | 69 |

GD was prepared as follows: 138 g of VEEA, 2 g of INHIB, 30 g of DISP, 30 g of Cyan and 30 g of Yellow were mixed using a DISPERLUX^{™} dispenser. Stirring was continued for 30 minutes. The vessel was connected to a NETZCH MiniZeta mill filled with 900 g of 0.4 mm yttrium stabilized zirconia beads ("high wear resistant zirconia grinding media" from TOSOH Co.). The mixture was circulated over the mill over 120 minutes (residence time of 45 minutes) and a rotation speed in the mill of about 10.4 m/s. During the complete milling procedure, the content in the mill was cooled to keep the temperature below 60° C. After milling, the dispersion was discharged into a vessel.

### Evaluation methods

### Viscosity

The viscosity of the inks was measured at 45 ° C and at a shear rate of 1000 s⁻¹ using a HAAKE RotoVisco 1.

For industrial inkjet printing, the viscosity at 45 ° C and at a shear rate of 1000 s⁻¹ is preferably less than 15 mPa.s. More preferably, the viscosity at 45° C and at a shear rate of 1000 s⁻¹ is from 5.0 to 15 mPa.s.

The viscosity was measured again after 7 days. An ink having a viscosity change of less than 20% is considered stable.

### ENIG Resistance

An ENIG simulation was carried out using a procedure as described below:
- The boards were dipped in a bath of acid cleaner (Umicore cleaner 865) at 40 ° C during 4 min. The boards were then removed and dipped in a rinsing bath of deionized water (DW) at room temperature (RT) during 90 seconds.
- The boards were dipped in a microetching bath comprising 8.5 wt% Na₂S₂0₈ and ± 3.2 wt% H₂SO₄ (98 %) in water at a temperature between 26-33 ° C for 100 s. The boards were then removed and rinsed in respectively DW, a 2.5 wt% aqueous H₂SO₄ solution and DW, all at RT during 90 seconds.
- The boards were dipped in 2.5 wt% aqueous H₂SO₄ solution at RT during 30 seconds after which they were removed and rinsed in DW at RT during 90 seconds. They were then dipped again in the same solution during 60 seconds.
- The boards were dipped in a palladium activator bath (Accemulta MKN 4) at a temperature around 30° C for 90 s followed by dipping in a 5 wt% aqueous H₂SO₄ solution at RT during 75 seconds. The boards were then removed and dipped in a rinsing bath of DW at RT during 90 seconds.
- Then the boards were dipped in a nickel bath (Nimuden NPR 4) at a temperature around 85 ° C for 35 min. The boards were then removed and dipped in a rinsing bath of DW at RT during 90 s.
- Finally, the boards were dipped in a gold bath (Gobright TAM 55) at a temperature around 80 ° C for 12 min. The boards were then removed and dipped in a rinsing bath of DW at RT during 90 s.

After ENIG treatment, it is possible that so-called blistering occurs, especially around open pads. In these areas, it appears that the ENIG solution penetrates and lifts up the solder mask layer. Besides blistering, it is also possible that a so-called "halo effect" is observed as an area around an open pad having a different appearance. Both phenomena could create weak adhesion points of the solder mask onto the substrate and may result in peeling off of the layer.

The occurrence of blisters was evaluated microscopically with a digital microscope Dino-LITE and scored with a value from 0 to 5, depending on the observed blistering density:
- 0: No blistering.
- 1: Blistering density less than 5% of the ink layer.
- 2: Blistering density less than 5-15% of the ink layer.
- 3: Blistering density less than 15-35% of the ink layer.
- 4: Blistering density less than 35-65% of the ink layer.
- 5: Blistering density more than 65% of the ink layer.

The occurrence of halo effect was evaluated microscopically with a digital microscope Dino-LITE and scored with a value from 0 to 5, depending on the observed width of the Halo.
- 0: No Hallo effect visible.
- 1: Halo width less than 1 mm.
- 2: Halo width from 1 mm to 2 mm.
- 3: Halo width from 2 mm to 3 mm.
- 4: Halo width from 3 mm to 4 mm.
- 5: Halo width more than 4 mm.

The adhesion after ENIG plating was evaluated with cross hatch adhesion test using Tesatape^{™} 4104 PVC tape. The evaluation was made in accordance with a criterion described below. The adhesion was evaluated both on Cu and FR-4.
- 0: Nothing removed, perfect adhesion.
- 1: Detachment of only very small parts of the cured layer, almost perfect adhesion.
- 2: Minor parts of the cured layer were removed by the tape, good adhesion.
- 3: Parts of the cured layer were removed by the tape, poor adhesion.
- 4: Most of the cured layer was removed by the tape, poor adhesion.
- 5: The cured layer was completely removed from the substrate by the tape, no adhesion.

### Solder resistance

The solder resistance of the inkjet inks was evaluated using a SPL600240 Digital Dynamic Solder Pot available from L&M PRODUCTS filled with a TSC puralloy SN100C solder alloy available from SOLDER CONNECTION. The temperature of the solder was set at 290 ° C.

Using a Q-tip, a solder flux SC7560A from SOLDER CONNECTION was applied on the surface of the samples to clean the surface. The solder flux was dried by placing the samples for 1 minute on each side above the solder pot. The remaining flux was wiped off with a soft tissue.

The sample was put in the solder pot for 10 seconds. This was reproduced 3 times in total after which the samples were cooled for at least 10 minutes.

The adhesion of the inkjet inks after solder dip test was evaluated after the printed samples were cooled down at room temperature. Then they were evaluated by visual observation of peeling off/delamination. Samples were ok if no peel off/adhesion loss was observed. If solder was observed on top of a printed layer, this was definite sign of a failed solder dip test (solder mask was peeled off and solder could attach to copper beneath it). The following scores were given to the printed samples after solder dip test, based on visual inspection:
- 0: no peel off, ink layer is not damaged.
- 1: slight peeling off of the ink layer. Less than 5 % of the ink layer peeled off.
- 2: 5 to 15 % of the ink layer has peeled off.
- 3: 15 to 35% of the ink layer has peeled off.
- 4: 35 to 65 % of the ink layer has peeled off.
- 5: More than 65% of the ink layer has peeled off.

The occurrence of blisters after solder dip test was evaluated microscopically with a digital microscope Dino-LITE and scored with a value from 0 to 5, depending on the observed blistering density:
- 0: No blistering.
- 1: Blistering density less than 5% of the ink layer.
- 2: Blistering density less than 5-15% of the ink layer.
- 3: Blistering density less than 15-35% of the ink layer.
- 4: Blistering density less than 35-65% of the ink layer.
- 5: Blistering density more than 65% of the ink layer.

### IR Reflow

A 40 *µ* m coating on FR-4 EM 825 was prepared by coating a 20 µm layer of the ink and curing 4 times using a 12W UV LED lamp. Then, a second 20 µm layer was applied and cured in the same way. Finally, the 40 µm coating was put in an oven for 1 hour at 150 ° C.

IR reflow evaluation was done using an eC-reflow-mate V4 reflow oven. The temperature inside the reflow oven was measured by three sensors. One at the top, one at the bottom and finally a central sensor to measure the temperature of the samples. The 40 µm coating was put into the IR eC-reflow-mate V4 reflow oven and placed above the central temperature sensor. The reflow cycle began by heating up the oven to 260° C. Once the sample temperature had reached 260° C, the oven holded the temperature for 10 seconds after which the sample was cooled down at open air. The duration of one cycle was 4min 30s. The ink coating underwent up to 6 IR reflow cycles (C1 to C6).

The evaluation of the samples was done visually by counting the number of cracks after each cycle.

### Examples 1 to 6 and Comparative Examples 1 to 5

The curable inkjet composition Ex-1 to Ex-6 and the comparative curable inkjet composition Comp-1 to Comp-5 were prepared according to Table 3. The weight percentages are based on the total weight of the curable inkjet composition.

**Table 3**

| | **Ex-1** | **Ex-2** | **Ex-3** | **Ex-4** | **Ex-5** | **Ex-6** | **Comp-1** | **Comp-2** | **Comp-3** | **Comp-4** | **Comp-5** |
|---|---|---|---|---|---|---|---|---|---|---|---|
| **GD** | 6.6 | 6.6 | 6.6 | 6.6 | 6.6 | 6.6 | 6.6 | 6.6 | 6.6 | 6.6 | 6.6 |
| **VEEA** | 12.8 | 12.8 | 12.8 | 12.8 | 12.8 | 12.8 | 12.8 | 12.8 | 12.8 | 17.8 | 18.2 |
| **PEA** | 31 | 31 | 31 | 31 | 31 | 31 | 31 | 31 | 31 | 31 | 31 |
| **ACMO** | 5 | 5 | 5 | 5 | 5 | 5 | 5 | 5 | 5 | 5 | 5 |
| **VMOX** | 5 | 5 | 5 | 5 | 5 | 5 | 5 | 5 | 5 | 5 | 5 |
| **EHMA** | 5 | - | - | - | - | - | - | - | - | - | 5 |
| **TMCHMA** | - | 5 | - | - | - | - | - | - | - | - | - |
| **IBOA** | - | - | - | - | - | - | 5 | - | - | - | - |
| **IBOMA** | - | - | 5 | - | - | - | - | - | - | - | - |
| **HDDA** | - | - | - | - | - | - | - | 5 | - | - | - |
| **HDDMA** | - | - | - | 5 | - | - | - | - | - | - | - |
| **TMPTA** | - | - | - | - | - | - | - | - | 5 | - | - |
| **TMPTMA** | - | - | - | - | 5 | - | - | - | - | - | - |
| **VEEM** | - | - | - | - | - | 5 | - | - | - | - | - |
| **PEGDA** | 15 | 15 | 15 | 15 | 15 | 15 | 15 | 15 | 15 | 15 | 15 |
| **DAROCUR ITX** | 0.6 | 0.6 | 0.6 | 0.6 | 0.6 | 0.6 | 0.6 | 0.6 | 0.6 | 0.6 | 0.6 |
| **BAPO** | 4.7 | 4.7 | 4.7 | 4.7 | 4.7 | 4.7 | 4.7 | 4.7 | 4.7 | 4.7 | 4.7 |
| **BISAPHOS** | 2 | 2 | 2 | 2 | 2 | 2 | 2 | 2 | 2 | 2 | 6 |
| **Trixene BI7960** | 7 | 7 | 7 | 7 | 7 | 7 | 7 | 7 | 7 | 7 | - |
| **Cymel NF2000A** | 2.4 | 2.4 | 2.4 | 2.4 | 2.4 | 2.4 | 2.4 | 2.4 | 2.4 | 2.4 | - |
| **WET** | 2 | 2 | 2 | 2 | 2 | 2 | 2 | 2 | 2 | 2 | 2 |
| **INHIB** | 0.9 | 0.9 | 0.9 | 0.9 | 0.9 | 0.9 | 0.9 | 0.9 | 0.9 | 0.9 | 0.9 |

The inkjet inks were printed using a MicroCraft CPS2013D (Printhead Konica Minolta KM1024iS, UV LED 395 12 W total output of the lamp) on a checkerboard (copper plated on FR4) substrate from Eurocircuits to obtain a soldermask layer having a final thickness of +/- 22 µm. The checkerboards include a 35 µm copper layer that was roughened by chemical etching. In the chemical etching step, the substrate was transported through a Bungard Sprint 3000 Conveyorized Spray Etch machine at a speed of 0.4 m/min while spraying with the chemical etchant CZ2001 (available from MEC) heated at 30° C. After a rinsing step with demineralized water an extra spraying step with 1M HCL was carried out, followed again by a rinsing step with demineralized water and a drying step in an Air 2000 dryer (available from Bungard). The substrate was printed within 24 h after this pretreatment.

After printing the samples were baked in an oven at 150° C for 1 hour.

Different printing protocols were used:
Print-1 (P1): An image having a resolution 1440 dpi in the x-direction and 1440 dpi in the y-direction was printed and cured. The UV energy applied corresponded to 10 % of the total power of the 12 W lamp. A final cure was applied to further cure the printed solder mask layer (4 passes at full energy of the 12 W lamp).
Print-2 (P2): Compared to Print 1, the image was printed and cured in two passes to achieve a certain thickness and the UV energy applied corresponded to 100 % of the total power of the 12 W lamp. A final cure was then carried out as described for Print-1.

The ENIG resistance and the IR reflow resistance of the inks was tested as described above. The results are shown in Table 4.

**Table 4**

| | **Viscosity** | | **ENIG resistance** | | | | | | | **IR reflow resistance** | | | | | |
|---|---|---|---|---|---|---|---|---|---|---|---|---|---|---|---|
| | **fresh (mPa.s)** | **Δ (%)** | **Blistering** | **HALO** | | **Adh. Cu** | | **Adh. FR-4** | | **C1** | **C2** | **C3** | **C4** | **C5** | **C6** |
| | | | **P1** | **P1** | **P2** | **P1** | **P2** | **P1** | **P2** | | | | | | |
| **Ex-1** | 6.46 | 10 | 0 | 2 | 1 | 0 | 0 | 0 | 0 | 0 | 0 | 0 | 0 | 0 | 0 |
| **Ex-2** | 6.62 | 20 | 0 | 3 | 1 | 0 | 0 | 0 | 0 | 0 | 0 | 0 | 0 | 0 | 0 |
| **Ex-3** | 6.93 | 22 | 0 | 1 | 0 | 0 | 0 | 0 | 0 | 0 | 0 | 0 | 0 | 0 | 0 |
| **Ex-4** | 6.92 | 12 | 0 | 3 | 0 | 0 | 0 | 0 | 0 | 0 | 0 | 0 | 0 | 0 | 0 |
| **Ex-5** | 7.45 | 3 | 0 | 2 | 0 | 0 | 0 | 0 | 0 | 0 | 0 | 0 | 0 | 0 | 0 |
| **Ex-6** | 6.59 | 10 | 0 | 2 | 0 | 0 | 0 | 0 | 0 | 0 | 0 | 0 | 0 | 0 | 0 |
| **Comp-1** | 7.07 | 9 | 0 | 1 | 0 | 0 | 0 | 0 | 0 | 0 | 0 | 0 | 2 | 2 | >3 |
| **Comp-2** | 6.91 | 8 | 0 | 1 | 0 | 0 | 0 | 0 | 0 | 0 | 0 | 0 | 2 | 2 | >3 |
| **Comp-3** | 7.46 | 13 | 0 | 1 | 0 | 0 | 0 | 0 | 0 | 0 | >3 | >3 | >3 | >3 | >3 |
| **Comp-4** | 6.79 | 3 | 2 | 1 | 0 | 0 | 0 | 0 | 0 | 0 | 0 | 0 | 0 | 2 | >3 |
| **Comp-5** | - | - | 1 | 5 | 3 | 5 | 0 | 0 | 0 | - | - | - | - | - | - |

It is clear from the above results that curable inks comprising a polymerizable compound and a thermal cross-linking agent have a good stability and a good ENIG resistance. Adding a methacrylate improves IR reflow resistance.

All inks had a perfect solder pot resistance after ENIG plating (not shown in the table).

### Examples 7 to 11 and Comparative Example 6

The curable inkjet composition Ex-7 to Ex-11 and the comparative curable inkjet composition Comp-6 were prepared according to Table 5. The weight percentages are based on the total weight of the curable inkjet composition.

**Table 5**

| | **Comp-6** | **Ex-7** | **Ex-8** | **Ex-9** | **Ex-10** | **Ex-11** |
|---|---|---|---|---|---|---|
| **GD** | 6.6 | 6.6 | 6.6 | 6.6 | 6.6 | 6.6 |
| **VEEA** | 17.8 | 15.3 | 12.8 | 10.3 | 7.8 | 5.3 |
| **PEA** | 31 | 31 | 31 | 31 | 31 | 31 |
| **ACMO** | 5 | 5 | 5 | 5 | 5 | 5 |
| **VMOX** | 5 | 5 | 5 | 5 | 5 | 5 |
| **EHMA** | | 2.5 | 5 | 7.5 | 10 | 12.5 |
| **PEGDA** | 15 | 15 | 15 | 15 | 15 | 15 |
| **DAROCUR ITX** | 0.6 | 0.6 | 0.6 | 0.6 | 0.6 | 0.6 |
| **BAPO** | 4.7 | 4.7 | 4.7 | 4.7 | 4.7 | 4.7 |
| **BISAPHOS** | 2 | 2 | 2 | 2 | 2 | 2 |
| **Trixene BI7960** | 7 | 7 | 7 | 7 | 7 | 7 |
| **Cymel NF2000A** | 2.4 | 2.4 | 2.4 | 2.4 | 2.4 | 2.4 |
| **WET** | 2 | 2 | 2 | 2 | 2 | 2 |
| **INHIB** | 0.9 | 0.9 | 0.9 | 0.9 | 0.9 | 0.9 |

The inkjet inks were printed in the same way as for Examples 1 to 6.

After printing the samples were baked in an oven at 150° C for 1 hour.

The used printing protocol is the following:
An image having a resolution 1440 dpi in the x-direction and 1440 dpi in the y-direction was printed and cured. The UV energy applied corresponded to 10 % of the total power of the 12 W lamp. A final cure was applied to further cure the printed solder mask layer (4 passes at full energy of the 12 W lamp).

The ENIG resistance and the solder resistance of the inks was tested and evaluated as described above. The results are shown in Table 6.

**Table 6**

| | **Viscosity** | | **ENIG resistance** | | | | **Solder Resistance** | |
|---|---|---|---|---|---|---|---|---|
| | **fresh (mPa.s)** | **Δ (%)** | **Blistering** | **HALO** | **Adh. Cu** | **Adh. FR-4** | **Delamination** | **Blistering** |
| **Comp-6** | 6.44 | 16 | 5 | 1 | 0 | 0 | 0 | 3 |
| **Ex-7** | 6.75 | 6 | 5 | 3 | 0 | 0 | 0 | 0 |
| **Ex-8** | 6.48 | 15 | 0 | 2 | 0 | 0 | 0 | 0 |
| **Ex-9** | 6.32 | 7 | 0 | 2 | 0 | 0 | 0 | 0 |
| **Ex-10** | 6.15 | 8 | 0 | 2 | 0 | 0 | 4 | 4 |
| **Ex-11** | 5.97 | 7 | 0 | 2 | 5 | 0 | 5 | 5 |

It is clear from the above results that curable inks comprising 2.5 wt% or less of 2-ethylhexyl methacrylate have a less good ENIG resistance and a good solder resistance. When there is 10 wt% or more of 2-ethylhexyl methacrylate, the solder resistance is less good while the ENIG resistance is good.

## Claims

1. A curable inkjet composition for a printed circuit board, comprising
- more than one polymerizable compound, of which at least one polymerizable compound contains a vinyl group selected from the group consisting of a vinylether group, an N-vinyl amide group and an N-vinyl carbamate group;
- one or more thermal cross-linking agent selected from the group consisting of an unblocked isocyanate, a blocked isocyanate and a triazine compound;
**characterized in that** at least one polymerizable compound is a methacrylate, wherein the amount of methacrylate is more than 2.5 wt% relative to the total weight of the curable inkjet composition.

2. The curable inkjet composition according to claim 1, wherein at least one polymerizable compound is selected from 2-(2-vinyloxyethoxy)ethyl acrylate, N-vinylcaprolactam, N-vinyl-2-pyrrolidone, and N-vinyl-5-methyl-2-oxazolidinone.

3. The curable inkjet composition according to claim 1 or 2, wherein at least one thermal cross-linking agent is a blocked isocyanate.

4. The curable inkjet composition according to claim 3, wherein the blocked isocyanate is a blocked HDI or IPDI oligomer, and wherein the oligomer is selected from the group consisting of a biuret, a trimethylolpropane adduct, and an isocyanurate.

5. The curable inkjet composition according to any of the preceding claims, wherein at least one thermal cross-linking agent is a triazine compound.

6. The curable inkjet composition according to claim 5, wherein the triazine compound has a chemical structure according to General Formula II 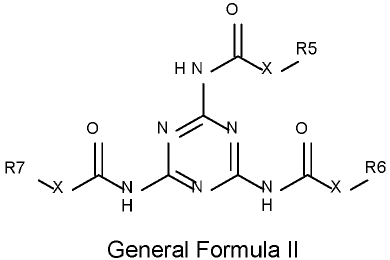 wherein
X represents N, O, S, P or C;
R5, R6 and R7 independently from each other represent a substituted or unsubstituted alkyl group.

7. The curable inkjet composition according to any of the preceding claims, wherein the amount of the methacrylate is at least 5 wt% relative to the total weight of the inkjet composition.

8. The curable inkjet composition according to any of the preceding claims, wherein one or more polymerizable compounds are selected from the group consisting of 2-ethylhexyl acrylate, lauryl acrylate, stearyl acrylate, 3,3,5-trimethylcyclohexyl acrylate, isobornyl acrylate, hexanediol diacrylate, trimethylolpropane triacrylate, polyethyleneglycol diacrylate, 2-phenoxyethyl acrylate, and acryloyl morpholine.

9. The curable inkjet composition according to any of the preceding claims, wherein the methacrylate is 2-ethylhexyl methacrylate, lauryl methacrylate, stearyl methacrylate, 3,3,5-trimethylcyclohexyl methacrylate, isobornyl methacrylate, hexanediol dimethacrylate, trimethylolpropane trimethacrylate, 2-(2'-vinyloxyethoxy)ethylmethacrylate or polyethyleneglycol dimethacrylate.

10. The curable inkjet composition according to any of the preceding claims, having a viscosity from 5 to 15 mPa.s measured at 45 °C at a shear rate of 1000 s⁻¹.

11. A cured product, obtained by applying and curing a curable inkjet composition as defined in any of the preceding claims on a substrate.

12. A method for manufacturing a printed circuit board comprising an inkjet printing step wherein a curable inkjet composition as defined in any of the claims 1 to 10 is jetted and cured on a substrate.

13. The method according to claim 12 also comprising a heating step.

14. The method according to claim 13 wherein the heating step is carried out at a temperature from 80 °C to 250 °C.

15. The method according to any of the claims 12 to 14 wherein the substrate is a dielectric substrate provided with an electrically conductive circuitry.

16. A PCB board comprising a solder mask, wherein the solder mask is obtained using a curable inkjet composition as defined in any of the claims 1 to 10.

## Patentansprüche

1. Eine härtbare Tintenstrahlzusammensetzung für eine Leiterplatte, umfassend
- mehr als eine polymerisierbare Verbindung, von denen mindestens eine polymerisierbare Verbindung eine Vinylgruppe, ausgewählt aus der Gruppe bestehend aus einer Vinylethergruppe, einer N-Vinylamidgruppe und einer N-Vinylcarbamatgruppe, enthält,
- ein oder mehrere thermische Vernetzungsmittel, ausgewählt aus der Gruppe bestehend aus einem nicht-blockierten Isocyanat, einem blockierten Isocyanat und einer Triazinverbindung,
**dadurch gekennzeichnet, dass** mindestens eine polymerisierbare Verbindung ein Methacrylat ist, wobei die Menge Methacrylat bei mehr als 2,5 Gew.-%, bezogen auf das Gesamtgewicht der härtbaren Tintenstrahlzusammensetzung, liegt.

2. Die härtbare Tintenstrahlzusammensetzung nach Anspruch 1, wobei mindestens eine polymerisierbare Verbindung aus 2-(2-Vinyloxyethoxy)-ethylacrylat, N-Vinylcaprolactam, N-Vinyl-2-pyrrolidon und N-Vinyl-5-methyl-2-oxazolidinon ausgewählt wird.

3. Die härtbare Tintenstrahlzusammensetzung nach Anspruch 1 oder 2, wobei mindestens ein thermisches Vernetzungsmittel ein blockiertes Isocyanat ist.

4. Die härtbare Tintenstrahlzusammensetzung nach Anspruch 3, wobei das blockierte Isocyanat ein blockiertes HDI- oder IPDI-Oligomer ist und das Oligomer aus der Gruppe bestehend aus einem Biuret, einem Trimethylolpropanaddukt und einem Isocyanurat ausgewählt wird.

5. Die härtbare Tintenstrahlzusammensetzung nach einem der vorstehenden Anspruche, wobei mindestens ein thermisches Vernetzungsmittel eine Triazinverbindung ist.

6. Die härtbare Tintenstrahlzusammensetzung nach Anspruch 5, wobei die Triazinverbindung eine chemische Struktur gemäß der allgemeinen Formel II hat 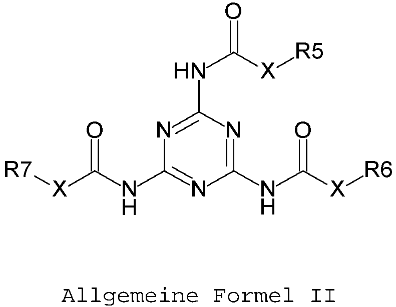 in der
X N, O, S, P oder C bedeutet,
R5, R6 und R7 unabhängig voneinander eine substituierte oder nicht-substituierte Alkylgruppe bedeuten.

7. Die härtbare Tintenstrahlzusammensetzung nach einem der vorstehenden Anspruche, wobei die Menge des Methacrylats bei mindestens 5 Gew.-%, bezogen auf das Gesamtgewicht der Tintenstrahlzusammensetzung, liegt.

8. Die härtbare Tintenstrahlzusammensetzung nach einem der vorstehenden Anspruche, wobei eine oder mehrere polymerisierbare Verbindungen aus der Gruppe bestehend aus 2-Ethylhexylacrylat, Laurylacrylat, Stearylacrylat, 3,3,5-Trimethylcyclohexylacrylat, Isobornylacrylat, Hexandioldiacrylat, Trimethylolpropantriacrylat, Polyethylenglycoldiacrylat, 2-Phenoxyethylacrylat und Acryloylmorpholin ausgewählt werden.

9. Die härtbare Tintenstrahlzusammensetzung nach einem der vorstehenden Anspruche, wobei das Methacrylat 2-Ethylhexylmethacrylat, Laurylmethacrylat, Stearylmethacrylat, 3,3,5-Trimethylcyclohexylmethacrylat, Isobornylmethacrylat, Hexandioldimethacrylat, Trimethylolpropantrimethacrylat, 2-(2'-Vinyloxyethoxy)-ethylmethacrylat oder Polyethylenglycoldimethacrylat ist.

10. Die härtbare Tintenstrahlzusammensetzung nach einem der vorstehenden Ansprüche mit einer bei einer Temperatur von 45 °C und einer Schergeschwindigkeit von 1.000 s⁻¹ gemessenen Viskosität zwischen 5 und 15 mPa.s.

11. Ein gehärtetes Produkt, das durch Auftrag und Härtung einer wie nach einem der vorstehenden Ansprüche definierten härtbaren Tintenstrahlzusammensetzung auf ein Substrat erhalten wird.

12. Ein Verfahren zur Herstellung einer Leiterplatte, umfassend einen Tintenstrahldruckschritt, in dem eine wie nach einem der Ansprüche 1 bis 10 definierte härtbare Tintenstrahlzusammensetzung auf ein Substrat aufgesprüht und gehärtet wird.

13. Das Verfahren nach Anspruch 12, das ebenfalls einen Heizschritt umfasst.

14. Das Verfahren nach Anspruch 13, wobei der Heizschritt bei eine Temperatur von 80 °C bis 250 °C ausgeführt wird.

15. Das Verfahren nach einem der Anspruche 12 bis 14, wobei das Substrat ein mit einem elektrisch leitenden Schaltkreis versehenes dielektrisches Substrat ist.

16. Eine Leiterplatte, umfassend eine Lötmaske, wobei die Lötmaske unter Verwendung einer wie nach einem der Ansprüche 1 bis 10 definierten härtbaren Tintenstrahlzusammensetzung erhalten wird.

## Revendications

1. Composition pour jet d'encre durcissable pour une carte de circuit imprimé, comprenant
- plus d'un composé polymérisable dont au moins un composé polymérisable contient un groupe vinyle choisi parmi le groupe composé d'un groupe éther vinylique, d'un groupe N-vinylamide et d'un groupe carbamate de N-vinyle,
- un ou plusieurs agents de réticulation thermique choisis parmi le groupe composé d'un isocyanate non bloqué, d'un isocyanate bloqué et d'un composé de triazine,
**caractérisée en ce qu'**au moins un composé polymérisable est un méthacrylate, **caractérisée en ce que** la quantité de méthacrylate est supérieure à 2,5% en poids par rapport au poids total de la composition pour jet d'encre durcissable.

2. Composition pour jet d'encre durcissable selon la revendication 1, **caractérisée en ce qu'**au moins un composé polymérisable est choisi parmi l'acrylate de 2-(2-vinyloxyéthoxy)-éthyle, la N-vinylcaprolactame, la N-vinyl-2-pyrrolidone et la N-vinyl-5-méthyl-2-oxazolidinone.

3. Composition pour jet d'encre durcissable selon la revendication 1 ou 2, **caractérisée en ce qu'**au moins un agent de réticulation thermique est un isocyanate bloqué.

4. Composition pour jet d'encre durcissable selon la revendication 3, **caractérisée en ce que** l'isocyanate bloqué est un oligomère de HDI ou IPDI bloqué et que l'oligomère est choisi parmi le groupe composé d'un biuret, d'un adduit de triméthylolpropane et d'un isocyanurate.

5. Composition pour jet d'encre durcissable selon l'une quelconque des revendications précédentes, **caractérisée en ce qu'**au moins un agent de réticulation thermique est un composé de triazine.

6. Composition pour jet d'encre durcissable selon la revendication 5, **caractérisée en ce que** le composé de triazine a une structure chimique répondant à la formule générale II 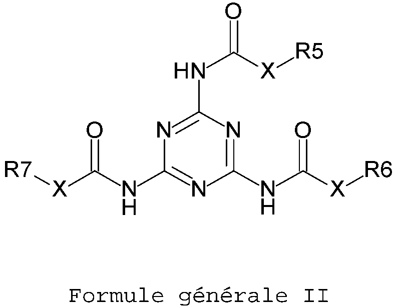 où
X représente N, O, S, P ou C,
R5, R6 et R7 représentent, indépendamment l'un de l'autre, un groupe alkyle substitué ou non substitué.

7. Composition pour jet d'encre durcissable selon l'une quelconque des revendications précédentes, **caractérisée en ce que** la quantité du méthacrylate s'élève à au moins 5% en poids par rapport au poids total de la composition pour jet d'encre.

8. Composition pour jet d'encre durcissable selon l'une quelconque des revendications précédentes, **caractérisée en ce qu'**un ou plusieurs composés polymérisables sont choisis parmi le groupe composé d'acrylate de 2-éthylhexyle, d'acrylate de lauryle, d'acrylate de stéaryle, d'acrylate de 3,3,5-triméthylcyclohexyle, d'acrylate d'isobornyle, de diacrylate d'hexanediol, de triacrylate de triméthylolpropane, de diacrylate de polyéthylèneglycol, d'acrylate de 2-phénoxyéthyle et de morpholine d'acryloyle.

9. Composition pour jet d'encre durcissable selon l'une quelconque des revendications précédentes, **caractérisée en ce que** le méthacrylate est le méthacrylate de 2-éthylhexyle, le méthacrylate de lauryle, le méthacrylate de stéaryle, le méthacrylate de 3,3,5-triméthylcyclohexyle, le méthacrylate d'isobornyle, le diméthacrylate d'hexanediol, le triméthacrylate de triméthylolpropane, le méthacrylate de 2-(2'-vinyloxyéthoxy)-éthyle ou le diméthacrylate de polyéthylèneglycol.

10. Composition pour jet d'encre durcissable selon l'une quelconque des revendications précédentes ayant une viscosité comprise entre 5 et 15 mPa.s, telle que mesurée à une température de 45 °C et à une vitesse de cisaillement de 1.000 s⁻¹.

11. Produit durci obtenu en appliquant et durcissant une composition pour jet d'encre durcissable telle que définie selon l'une quelconque des revendications précédentes sur un substrat.

12. Procédé pour la fabrication d'une carte de circuit imprimé comprenant une étape d'impression à jet d'encre dans laquelle une composition pour jet d'encre durcissable telle que définie selon l'une quelconque des revendications 1 à 10 est projetée et durcie sur un substrat.

13. Procédé selon la revendication 12 comprenant également une étape de chauffage.

14. Procédé selon la revendication 13, **caractérisé en ce que** l'étape de chauffage est effectuée à une température comprise entre 80 °C et 250 °C.

15. Procédé selon l'une quelconque des revendications 12 à 14, **caractérisé en ce que** le substrat est un substrat diélectrique pourvu d'un circuit électroconducteur.

16. Carte de circuit imprimé comprenant un masque de soudure, **caractérisée en ce que** le masque de soudure est obtenue en utilisant une composition pour jet d'encre durcissable telle que définie selon l'une quelconque des revendications 1 à 10.
